# EUROPÄISCHE PATENTANMELDUNG

(11) **EP 2 549 552 A2**
(43) Veröffentlichungstag der Anmeldung: **23.01.2013**
(21) Anmeldenummer: 12176630.7
(22) Anmeldetag: 17.07.2012
(51) Int. Cl.: H01L 31/048, H01L 31/05

(54) **Solarzellenbaustein und Solarzellenanordnung**

(30) Priorität: 20.07.2011 DE 102011079505
(71) Anmelder: ROBERT BOSCH GMBH, 70442 Stuttgart (DE)
(72) Erfinder: Ramsteiner, Ingo, 71229 Leonberg (DE)

(57) **Zusammenfassung**

Es wird ein Solarzellenbaustein (7;7.1;7.2;7.3) zur Bildung einer Solarzellenanordnung aus einer Vielzahl von zu Strings (S1;S2;S3) verschalteten Solarzellen (3) vorgeschlagen, wobei dieser mit
- einer Solarzelle (3),
- einem die Solarzelle verkapselnden Gehäuse (9), das zumindest über der Vorderseite der Solarzelle eine für Sonnenlicht durchlässige Wandung hat, und
- einer zusammen mit der Solarzelle in das Gehäuse eingeschlossenen Leiteranordnung (1;11) mit in Randbereichen des Gehäuses platzierten elektrischen Anschlusskontakten (BC;BC';FC;FC';G)

versehen ist. Ferner wird eine Solarzellenanordnung aus einer Mehrzahl von Solarzellenbausteinen (7;7.1;7.2;7.3) beschrieben.

## Beschreibung

Die Erfindung betrifft einen Solarzellenbaustein zur Bildung einer Solarzellenanordnung aus einer Vielzahl von zu Strings verschalteten Solarzellen sowie eine aus derartigen Bausteinen gebildete Solarzellenanordnung.

### Stand der Technik

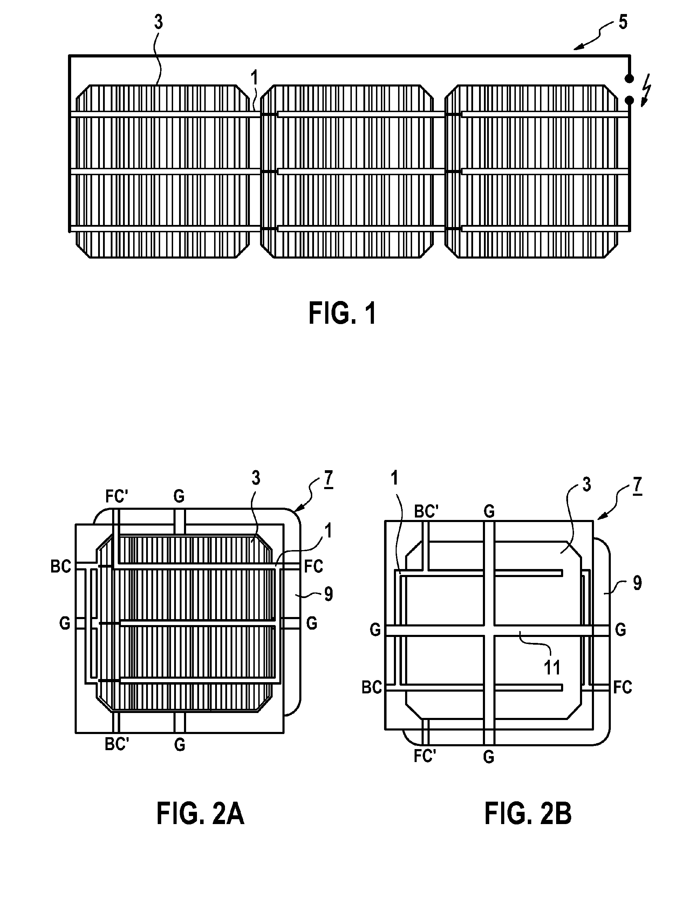

Bei der Fertigung von Solarmodulen werden nach heutigem Stand der Technik die einzelnen (mono- oder polykristallinen) Zellen zunächst, wie in Fig. 1 skizziert, zu sogenannten "Strings" verschaltet. Dabei verbinden dünne Metallbänder 1 jeweils (nicht gesondert bezeichnete) Frontkontakte einer Solarzelle 3 mit den Rückkontakten der nächsten, so dass alle (z. B. 10) Zellen eines Strings in Reihe geschaltet sind. Mehrere Strings werden dann, beispielsweise durch Einlaminieren in einem Glas-Kunststoff-Verbund, zu einem Modul verbaut. Gezeigt ist ein String 5 aus drei Zellen, in der Praxis bestehen die Strings aus ca. 10 Zellen.

Ein großer Nachteil des oben beschriebenen Verfahrens ist, dass die einzelnen Zellen vom Zeitpunkt der Verschaltung zu einem String an nur noch schwer austauschbar sind. Dies ist nicht erst im Betrieb, sondern bereits bei der Fertigung ein Problem, da die Verschaltung einen sehr frühen Prozessschritt darstellt. Beim Festlöten der Bändchen, beim Handling durch Roboter und beim Laminieren unter hohem Druck und bei hoher Temperatur sind die extrem dünnen und brüchigen Zellen immer wieder mechanischen und thermischen Belastungen ausgesetzt, ein Problem, das sich in Zukunft durch dünnere Zellen und höhere Taktraten immer weiter verschärfen wird. Eine beschädigte Zelle setzt oft den ganzen String außer Funktion, sie muss also ersetzt werden. Dies wird mit jedem weiteren Prozessschritt schwieriger, und ist nach dem Laminieren gar nicht mehr möglich.

Der Wirkungsgrad von kristallinen Solarzellen mit Frontkontaktierung wird dadurch signifikant verringert, dass das metallische Kontaktgitter auf der Vorderseite die Zelle typischerweise 7-10% der einfallenden Sonnenstrahlung abschattet. Eine auf die Kontaktgeometrie abgestimmte Oberflächenstruktur des Deckglases könnte dies durch gezielte Lichtführung deutlich reduzieren. Dazu ist aber eine Positioniergenauigkeit zwischen Zelle und Deckglas erforderlich, die im herkömmlichen Fertigungsverfahren nur schwer erreichbar ist. Dies gilt insbesondere für die Adressierung der feinen, eng beieinander liegenden Gitterlinien. Eine effiziente Lichtführung für Letztere erfordert außerdem ein deutlich dünneres Deckglas, welches bei heutiger Modulbauweise keine ausreichende mechanische Stabilität hätte.

### Offenbarung der Erfindung

Mit der Erfindung wird ein Solarzellenbaustein mit den Merkmalen des Anspruchs 1 bereitgestellt. Des Weiteren wird eine Solarzellenanordnung aus einer Mehrzahl derartiger Solarzellenbausteine vorgeschlagen.

Die Erfindung schließt den Gedanken ein, vom bisherigen Konzept der Bildung von Solarzellenanordnungen aus nur elektronisch funktionsfähigen Halbleiterbauelementen, deren mechanische Beschaffenheit in keiner Weise den Gebrauchsanforderungen entspricht, abzugehen. Sie schließt weiterhin den Gedanken ein, von der bisher üblichen Schrittfolge einer primären elektrischen Verschaltung dieser Halbleiterbauelemente und einer sekundären, also nachfolgenden Weiterverarbeitung zur mechanischen Stabilisierung und zum Schutz vor Umwelteinflüssen abzugehen. Zur Erfindung gehört demnach der Gedanke, jede einzelne Solarzelle mit einem die Solarzelle verkapselnden Gehäuse, das zumindest über der Vorderseite der Solarzelle eine für Sonnenlicht durchlässige Wandung hat, zu versehen. Weiterhin gehört zur Erfindung der Gedanke des Vorsehens einer zusammen mit der Solarzelle in das Gehäuse eingeschlossenen Leiteranordnung mit in Randbereichen des Gehäuses platzierten elektrischen Anschlusskontakten.

In einer zweckmäßigen Ausführung ist das Gehäuse mindestens teilweise aus Kunststoff, wie einem Polymethyl-Methacrylat oder Polycarbonat oder ähnlichem, gebildet. Aus derzeitiger Sicht bevorzugt ist ein vollständig aus Kunststoff bestehendes Gehäuse, welches in verfahrenstechnisch leicht zu handhabender und kostengünstiger Ausführung insbesondere als Spritzgussteil ausgebildet ist.

In einer weiteren Ausführung weist das Gehäuse an mindestens zwei Kantenbereichen mechanische Verbindungsmittel zur Verbindung benachbarter Solarzellenbausteine miteinander auf. Hierbei sind insbesondere die mechanischen Verbindungsmittel vom Nut-Feder-Typ oder Schwalbenschwanz-Typ oder Haken-Öse-Typ, und/oder sie weisen Rastmittel auf. Die konkrete konstruktive Ausgestaltung der mechanischen Verbindungsmittel ist sinnvollerweise derart, dass ein einzelner Baustein ohne zeitaufwändiges und störanfälliges Handling der übrigen Bausteine einer Anordnung aus dieser heraus gelöst und ein Ersatz-Baustein oder der instandgesetzte ursprüngliche Baustein ebenso unaufwendig wieder in diese eingefügt werden kann.

Weitere sinnvolle Ausführungen ergeben sich im Hinblick auf die elektrische Funktion des Bausteins. So ist in einer Ausführung vorgesehen, dass die Leiteranordnung einen isoliert von der Solarzelle verlegten Überbrückungsleiter mit zugehörigen Anschlusskontakten in mindestens zwei Randbereichen aufweist. Eine weitere Ausführung, die mit der vorgenannten kombinierbar, aber auch unabhängig davon praktikabel ist, sieht vor, dass in die Leiteranordnung ein zusätzliches elektrisches oder elektronisches Bauelement, insbesondere eine Bypass-Diode, oder eine elektronische Baugruppe eingebunden ist.

In einer weiteren Ausführung ist mindestens ein Teil der Anschlusskontakte als Steckkontakte ausgebildet. Dies ermöglicht eine besonders leichte und schnelle Montage und, falls erforderlich, Demontage der Solarzellenanordnung bzw. Entnahme eines einzelnen Bausteins. Andererseits kann vorgesehen sein, dass mindestens ein Teil der Anschlusskontakte für eine Lötverbindung ausgebildet ist. Für eine solche Ausführung spricht der dauerhaft niedrige Durchgangswiderstand und die hohe Zuverlässigkeit von Lötverbindungen über eine lange Betriebsdauer. Unter diesem Aspekt ist auch eine Ausführung vorteilhaft, bei der die Anschlusskontakte korrosionsfest ausgebildet sind. Beispielsweise kann hierfür korrosionsfestes Material in Form einer elektrisch leitenden Schutzschicht auf die Anschlusskontakte aufgebracht sein oder dem Anschlusskontakt als Zumischung zugefügt sein.

### Mit anderen Worten:

Die Erfindung sieht vor, bereits die einzelne Zelle in einem transparenten Kunststoffgehäuse zu verkapseln und die Kontakte nach außen zu führen. Diese Einheit wird hier als Solarzellenbaustein bezeichnet. Die Leiterbahnen sind gemeinsam mit der Zelle in den Kunststoff eingebettet und lediglich über freiliegende (oder bei Inbetriebnahme freigelegte) Kontakte am Rand zugänglich. Insbesondere führen jeweils ein oder mehrere Kontakte zum Frontkontakt der Zelle (FC) und zum Rückkontakt (BC). Außerdem kann der Baustein noch einen von der Zelle elektrisch isolierten Leiter enthalten, der an zwei oder mehr Seiten über die Kontakte (G) zugänglich ist. Zahl und Anordnung der Kontakte hängt davon ab, in welchen Anordnungen sich die einzelnen Zellmodule später verbinden lassen sollen. Es ist vorteilhaft, die Zellgehäuse mit einem Verbindungsmechanismus auszustatten, also z. B. wie in der Skizze mit einem Nut- und Feder-Mechanismus.

Zu beachten ist, dass bei der Modulfertigung nach Stand der Technik die Wahl der Modulgeometrie ganz am Anfang der Fertigung steht - bei der Auswahl des Frontglases. Alle folgenden Fertigungsschritte (Verstringen, parallele Kontaktierung, Lamination etc.) müssen dann an das Format angepasst werden. Bei dem hier vorgeschlagenen Konzept wird die Modulgeometrie ganz am Ende der Fertigungskette festgelegt - beim Zusammenfügen der einzelnen Zellmodule. In einer anders gestalteten Herstellungskette könnte die Verschaltung sogar erst durch den Solar-Installateur erfolgen, der dadurch maßgeschneiderte Lösungen für spezielle Flächen anbieten kann.

Die zwei wesentlichen Fertigungsschritte der verkapselten Zelle sind also nach Obigem:
1. Kontaktierung mit Metallbändern: Dieser Schritt ist fertigungstechnisch identisch mit dem entsprechenden Vorgang im sog. "Stringer" und erfolgt nach Stand der Technik durch Löten. Gegenüber dem etablierten Verfahren besteht die wesentliche Vereinfachung, dass nur eine einzelne Zelle kontaktiert wird, nicht ein ganzer String.
2. Einkapselung in Kunststoff: Die Zelle wird in einem oder mehreren Schritten (beispielsweise durch Spritzguss) in eine Kunststoffkapsel (beispielsweise Polymethyl-Methacrylat oder Polycarbonat) eingebettet, die zumindest auf einer Seite (die spätere Sonnenseite) transparent ist. Die Kontaktbändchen sind nach außen geführt. Die Verkapselung ist vorzugsweise rechteckig, insbesondere quadratisch, um eine lückenlose Anordnung der einzelnen Einheiten zu ermöglichen. Vorzugsweise sind an den Kanten mechanische Vorrichtungen vorgesehen, um die Zellen zu verbinden (z. B. Nut- und FederElemente) oder auszurichten (Vorsprünge und Kerben).

In einer weiteren Ausführung der Erfindung weist das Gehäuse an der Vorderseite der Solarzelle eine zur Verringerung von Abschattungseffekten durch eine Leiterstruktur der Solarzelle ausgebildete Oberflächenstruktur und/oder eine Antireflexbeschichtung und/oder eine Hartbeschichtung zur Erhöhung der Kratzfestigkeit auf.

Da die Abschattung durch die Frontkontakte 7% und mehr beträgt, erscheint eine Gesamtsteigerung der Zelleffizienz gegenüber einer unstrukturierten Oberfläche um einen Prozentpunkt nicht unrealistisch. Ein zusätzlicher ästhetischer Vorteil besteht darin, dass das Kontaktgitter gar nicht mehr sichtbar ist. Ursache ist die Reziprozität in der geometrischen Optik: so wie das Sonnenlicht von den Kontakten weggelenkt wird, wird auch das Licht von den Kontakten vom Betrachter weggelenkt. Die Maßnahme erfordert lediglich die geeignete Strukturierung des Formwerkzeugs und würde keine zusätzlichen Kosten verursachen. Durch eine Antireflex-Beschichtung lässt sich eine weitere Effizienzsteigerung der Solarzellenanordnung erreichen.

Zusammengefasst bietet die Erfindung, jedenfalls in einer oder mehreren der oben genannten Ausführungen, folgende Vorteile gegenüber dem Bekannten:
- Die verkapselten Zellen lassen sich bei der weiteren Verarbeitung (Modulfertigung) leichter handhaben, die Verluste durch Bruch würden sich reduzieren.
- Es gibt weniger Ausschuss bei Modulfertigung, da beschädigte oder schlecht kontaktierte Zellen problemlos ausgetauscht werden können.
- Bei Beschädigungen (Steinschlag, Vandalismus, Korrosion) kann das Gesamtmodul durch Austausch der defekten Zellmodule repariert werden.
- Eine Umstellung des Modulformats betrifft nur noch den letzten Fertigungsschritt, keine weiteren Eingriffe in die Fertigungslinie sind nötig.
- Die Zelle ist in der Kunststoffkapsel gegen Witterungseinflüsse geschützt. Glasplatte, Rückplatte und Laminierfolien sind nicht mehr erforderlich.
- Es gibt eine deutliche Gewichtsersparnis bei Verzicht auf die Frontglasplatte, die bei konventionellen Modulen mehr als 10kg wiegt. Dadurch ergeben sich eine Reduzierung der Dachlast, erleichterte Installation und höhere Sicherheit.
- Es besteht die Möglichkeit der Integration einer lichtführenden Struktur, die den Wirkungsgrad signifikant (ca. 1% bei sauberer Oberfläche) verbessert. Die Frontkontakte sind dann nicht mehr sichtbar.
- Es lassen sich zusätzliche Marktsegmente bei Erweiterung des Geschäftsmodells (Installateur- oder Heimwerkermarkt) erschließen.

### Zeichnungen

Weitere Vorteile und vorteilhafte Ausgestaltungen der erfindungsgemäßen Gegenstände werden durch die Zeichnungen veranschaulicht und in der nachfolgenden Beschreibung erläutert. Dabei ist zu beachten, dass die Zeichnungen nur beschreibenden Charakter haben und nicht dazu gedacht sind, die Erfindung in irgendeiner Form einzuschränken. Es zeigen:
- Fig. 1: eine schematische Darstellung eines auf bekannte Weise hergestellten Solarzellen-Strings,
- Fig. 2A und 2B: schematische Draufsichten auf die Vorder- bzw. Rückseite eines erfindungsgemäßen Solarzellenbausteins,
- Fig. 3: eine schematische Darstellung zur Erläuterung der Bildung einer ersten Ausführung eines Solarzellen-Strings aus erfindungsgemäßen Solarzellenbausteinen,
- Fig. 4: eine schematische Darstellung zur Erläuterung der Bildung einer zweiten Ausführung eines Solarzellen-Strings aus erfindungsgemäßen Solarzellenbausteinen,
- Fig. 5: eine schematische Darstellung einer Solarzellenanordnung im Giebelbereich eines Wohnhauses,
- Fig. 6: eine Skizze zur Erläuterung einer Vorderseiten-Strukturierung bei einer Ausführungsform des erfindungsgemäßen Solarzellenbausteins und
- Fig. 7A und 7B: skizzenartige Darstellungen der Randbereiche zweier benachbarter Solarzellenbausteine gemäß Ausführungsformen der Erfindung.

Fig. 2A zeigt die Vorderseite und Fig. 2B die Rückseite eines erfindungsgemäßen Solarzellenbausteins **7,** der neben einer Solarzelle **3** ein Kunststoffgehäuse **9** und eine Mehrzahl von in dieses zusammen mit der Solarzelle eingebetteten Leitern **1** umfasst, die über freiliegende Kontakte im Randbereich des Bausteins **7** zugänglich sind. Mit **FC** und **FC'** sind Frontkontakte und mit **BC** bzw. **BC'** Rückkontakte des Bausteins bezeichnet, die zu entsprechenden Kontakten der Solarzelle **3** führen. Wie in Fig. 1 sind die Metallbänder zur Miteinander-Verschaltung benachbarter Solarzellen mit Ziffer **1** bezeichnet. Daneben enthält das Gehäuse **9** eine gegenüber der Solarzelle isolierte Leiterstruktur (einen Überbrückungsleiter) **11** mit kantenseitigen Anschlusskontakten **G.**

Die Darstellung in Fig. 2A und 2B ist lediglich beispielhaft; konkrete Zahl und Anordnung der Leiter und Kontakte bei einem praktisch realisierten Solarzellenbaustein hängt davon ab, in welchen Anordnungen sich die Bausteine bei der Zusammenstellung einer Solarzellenanordnung in einem späteren Montageschritt verbinden lassen sollen.

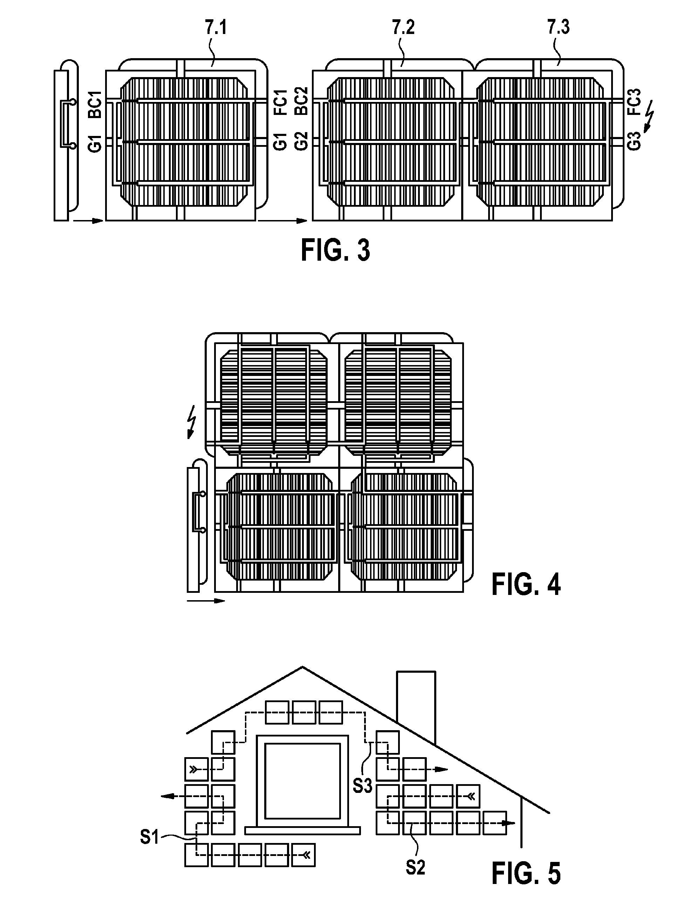

Fig. 3 zeigt, wie drei Solarzellenbausteine **7.1, 7.2** und **7.3** der in Fig. 2A und 2B genauer gezeigten Art zu einem String zusammengefügt werden können.

Der Frontkontakt **FC1** des ersten Solarzellenbausteins kontaktiert den Rückkontakt **BC1** des zweiten, der Frontkontakt des zweiten Solarzellenbausteins wiederum den Rückkontakt des dritten usw. An einem Ende dieser Anordnung wird der freie Kontakt **BC1** mit einem Kontakt **G** verbunden, beispielsweise, wie dargestellt, über einen entsprechenden Terminierungs-Stecker. Die über die gesamte Serienverschaltung anliegende Spannung kann dann an dem anderen Ende (in der Abbildung zwischen **FC3** und **G3**) abgegriffen werden.

Mehrere solche Anordnungen können in einem geeigneten Rahmen zu einem Gesamtmodul angeordnet und parallel verschaltet werden. Dies entspricht im Prinzip einem herkömmlichen Solarzellenbaustein mit parallel verschalteten Zellstrings. Alternativ kann bei entsprechender Konfektionierung der Kontakte auch eine Anordnung realisiert werden, bei denen seriell verschaltete Solarzellenbausteine nicht in einer geraden Linie verbunden sind. Ein Beispiel zeigt Fig. 4. Hier wurden zwei Solarzellenbausteine mit verschiedenen Kontakt-Konfigurationen verwendet: die erste (links unten) entspricht der aus Fig. 3 (also nur jeweils ein **FC** bzw. **BC**), die anderen drei Zellen sind wie in Fig. 2 konfektioniert (mit zusätzlichen Kontakten **BC'** und **FC'**). Diese zwei Solarzellenbaustein-Ausführungen erlauben es bereits, eine Vielzahl von Anordnungen zu realisieren, weitere Kontaktierungs-Varianten würden die Möglichkeiten noch erweitern.

Beim Zusammenfügen der Solarzellenbausteine können die aneinander anstoßenden Kantenbereiche mit einer wetterfesten Versiegelung vorgesehen sein, oder es können flexible Dichtleisten bereits an Kanten der Solarzellenbausteine vorgesehen sein. Beide Wetterschutzmaßnahmen können auch miteinander kombiniert sein.

Fig. 5 zeigt an einem Beispiel, wie sich mit erfindungsgemäßen Solarzellenbausteinen Solarzellenanordnungen mit einer von der allgemein üblichen Rechteckform abweichenden geometrischen Konfiguration realisieren und hierdurch Außenwandflächen von Bauwerken effizienter zur Energiegewinnung nutzen lassen. Die Teile **S1, S2** und **S3** symbolisieren drei spezifisch vorkonfigurierte Solarzellen-Strings, die gemeinsam schließlich eine weitgehend vollständig belegte Giebelfläche eines Hauses ergeben.

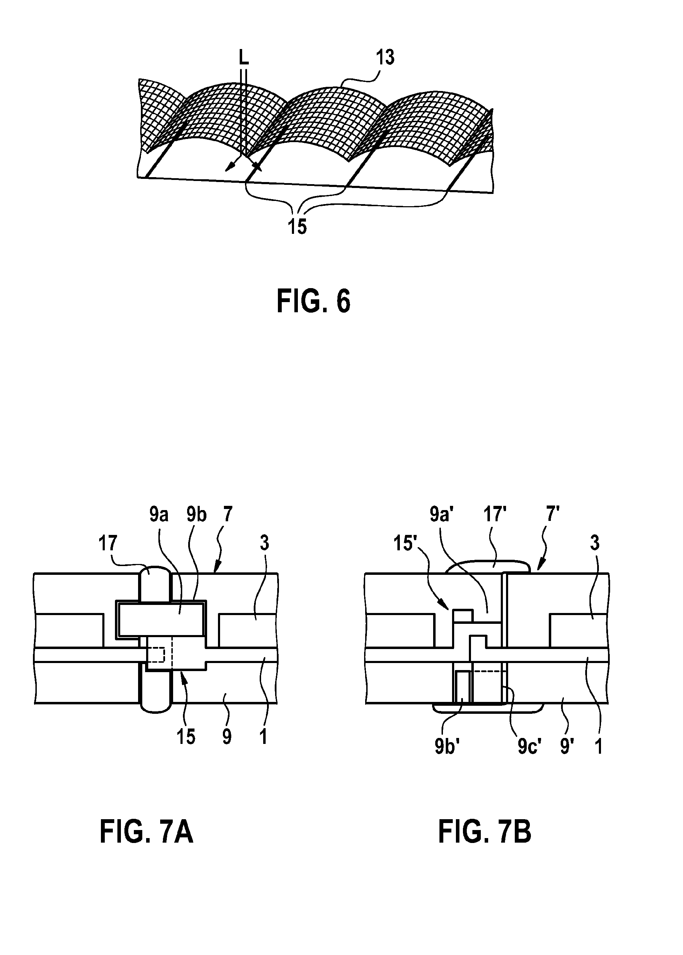

Fig. 6 zeigt skizzenartig eine Oberflächenstruktur einer Ausführungsform des erfindungsgemäßen Solarzellenbausteins, die eine Anordnung von tonnenförmigen Aufwölbungen **13** über einem Grid **15**, also parallel verlaufenden Leiterzügen auf der Vorderseite einer (nicht dargestellten) Solarzelle zeigt. Die Schnittlinien der Aufwölbungen **13** liegen über den Leiterzügen des Grids **15** und erbringen so eine geeignete Führung von einfallendem Licht **L** zur weitgehenden Vermeidung von Abschattungseffekten.

Fig. 7A und 7B zeigen jeweils in schematischen Schnittdarstellungen die aneinander angrenzenden Kantenbereiche zweier Solarzellenbausteine **7** im Detail, speziell die dort vorgesehenen Verbindungsmittel zur elektrischen und mechanischen Verbindung beider Bausteine. Bei der Ausführung gemäß Fig. 7A ist zur mechanischen Verbindung eine Feder **9a** vorgesehen, die in kantenseitige Gehäusenuten **9b** der Gehäuse **9** eingreift. Die elektrische Verbindung zwischen Leitern **1** beider Zellen ist als Steckverbindung **15** ausgeführt. Zur wetterfesten Versiegelung des Kantenbereiches ist vorder- und rückseitig jeweils eine Dichtmasse **17** eingebracht.

Konstruktiv modifizierte Solarzellenbausteine **7'** gemäß Fig. 7B haben ein Gehäuse **9',** das zur Verbindung nach dem Haken-Öse-Prinzip einerseits Haken **9a'** und andererseits eine vorspringende Kante **9b'** mit Ausnehmungen **9c'** zum Eingriff der Haken **9a'** aufweist. Zum Schutz vor Witterungseinflüssen sind jeweils vormontierte, über die Kante überstehende Dichtlippen **17'** vorgesehen. Auch hier sind zur elektrischen Verbindung Steckverbinder **15'** vorgesehen, deren Aufbau aber in Anpassung an die andere Art der mechanischen Verbindung modifiziert ist.

Die Ausführung der Erfindung ist nicht auf die oben beschriebenen Beispiele und hervorgehobenen Aspekte beschränkt, sondern ebenso in einer Vielzahl von Abwandlungen möglich. Auf folgende Abwandlungen wird hiermit besonders hingewiesen:
- Auch sechseckige Elemente erlauben eine lückenlose Anordnung, was insbesondere bei sehr unregelmäßig geformten Flächen von Vorteil sein kann. Entsprechend sechseckige (oder kreisförmige) Solarzellen sind gleichzeitig vorteilhaft, weil sie den Waferverschnitt reduzieren.
- Eine weiter oben erwähnte Ausführung sieht eine Verbindung der einzelnen Elemente durch einen Nut- und Feder-Mechanismus mit integrierten Kontakten vor. Alternativ sind auch Zapfen oder Zinken als Verbinder denkbar. Mechanische und elektrische Verbindung kann auch durch Metallstifte- oder Stecker kombiniert werden. Speziell für den Heimwerkermarkt interessant wäre insbesondere, durch entsprechende Steckerformen und -Anordnungen an den verschiedenen Kanten eine elektrisch fehlerhafte Anordnung der einzelnen Zellen zu verhindern.
- Ein weiteres Kontaktierungskonzept wäre, die Kontakte gar nicht nach außen zu führen und nur mittels mechanischer Bohrung zugänglich zu machen. Die Verbindung erfolgt dann z. B. über aufsteckbare Brücken. Dies erlaubt besonders vielseitig einsetzbare Elemente und vermeidet gleichzeitig "freie" Kontakte, die die Verkapselung unnötig durchbrechen.

## Patentansprüche

1. Solarzellenbaustein (7;7.1;7.2;7.3) zur Bildung einer Solarzellenanordnung aus einer Vielzahl von zu Strings (S1;S2;S3) verschalteten Solarzellen (3), mit
- einer Solarzelle (3),
- einem die Solarzelle verkapselnden Gehäuse (9), das zumindest über der Vorderseite der Solarzelle eine für Sonnenlicht durchlässige Wandung hat, und
- einer zusammen mit der Solarzelle in das Gehäuse eingeschlossenen Leiteranordnung (1;11) mit in Randbereichen des Gehäuses platzierten elektrischen Anschlusskontakten (BC;BC';FC;FC';G).

2. Solarzellenbaustein nach Anspruch 1,
wobei das Gehäuse (9) mindestens teilweise aus Kunststoff, wie einem Polymethyl-Methacrylat oder Polycarbonat oder ähnlichem, gebildet ist.

3. Solarzellenbaustein nach Anspruch 2,
wobei das Gehäuse (9) als Spritzgussteil ausgebildet ist.

4. Solarzellenbaustein nach einem der vorangehenden Ansprüche,
wobei das Gehäuse (9) an mindestens zwei Kantenbereichen mechanische Verbindungsmittel (15;15') zur Verbindung benachbarter Solarzellenbausteine miteinander aufweist.

5. Solarzellenbaustein nach Anspruch 4,
wobei die mechanischen Verbindungsmittel vom Nut-Feder-Typ (9a;9b) oder Schwalbenschwanz-Typ oder Haken-Öse-Typ (9a';9b';9c') sind und/oder Rastmittel aufweisen.

6. Solarzellenbaustein nach einem der vorangehenden Ansprüche,
wobei die Leiteranordnung (1;11) einen isoliert von der Solarzelle verlegten Überbrückungsleiter (11) mit zugehörigen Anschlusskontakten (G) in mindestens zwei Randbereichen aufweist.

7. Solarzellenbaustein nach einem der vorangehenden Ansprüche,
wobei in die Leiteranordnung (1;11) ein zusätzliches elektrisches oder elektronisches Bauelement, insbesondere eine Bypass-Diode, oder eine elektronische Baugruppe eingebunden ist.

8. Solarzellenbaustein nach einem der vorangehenden Ansprüche,
wobei mindestens ein Teil der Anschlusskontakte (BC;BC';FC;FC';G) als Steckkontakte (15;15') ausgebildet ist.

9. Solarzellenbaustein nach einem der vorangehenden Ansprüche,
wobei mindestens ein Teil der Anschlusskontakte (BC;BC';FC;FC';G) für eine Lötverbindung ausgebildet ist.

10. Solarzellenbaustein nach einem der vorangehenden Ansprüche,
wobei die Anschlusskontakte (BC;BC';FC;FC';G) korrosionsfest ausgebildet sind.

11. Solarzellenbaustein nach einem der vorangehenden Ansprüche,
wobei das Gehäuse (9) an der Vorderseite der Solarzelle eine zur Verringerung von Abschattungseffekten durch eine Leiterstruktur der Solarzelle ausgebildete Oberflächenstruktur (13) und/oder eine Antireflexbeschichtung und/oder eine Hartbeschichtung zur Erhöhung der Kratzfestigkeit aufweist.

12. Solarzellenanordnung aus einer Mehrzahl von Solarzellenbausteinen auch einem der vorangehenden Ansprüche.

13. Solarzellenanordnung nach Anspruch 12,
wobei die Solarzellenbausteine (7;7.1;7.2;7.3) mechanisch und elektrisch lösbar miteinander verbunden sind.

14. Solarzellenanordnung nach Anspruch 12 oder 13,
wobei in den Randbereichen benachbarter Solarzellenbausteine (7;7.1;7.2;7.3) eine wetterfeste Versiegelung (17;17') vorgesehen ist.

15. Solarzellenanordnung nach einem der Ansprüche 12 bis 14, mit einer von der Rechteckform abweichenden Gesamtform.
